Europäisches Patentamt

European Patent Office

Office européen des brevets

(11) Publication number : **0 517 469 A2**

# EUROPEAN PATENT APPLICATION

(21) Application number : **92305021.5**

(22) Date of filing : **02.06.92**

(51) Int. Cl.⁵ : **H01L 39/24**

(30) Priority : **05.06.91 GB 9112109**

(43) Date of publication of application :
**09.12.92 Bulletin 92/50**

(84) Designated Contracting States :
**DE FR GB IT NL**

(71) Applicant : **CAMBRIDGE ADVANCED MATERIALS LIMITED**
**193 Coleridge Road**
**Cambridge CB1 3PW (GB)**

(72) Inventor : **Evetts, Jan Edgar**
**53 Owlstone Road**
**Cambridge (GB)**
Inventor : **Arnott, Michael George**
**38 Blinco Grove**
**Cambridge CB1 4TS (GB)**

(74) Representative : **Perry, Robert Edward**
**GILL JENNINGS & EVERY 53-64 Chancery Lane**
**London WC2A 1HN (GB)**

(54) **Melt-texturing of superconductors.**

(57)   A precursor material is converted to a superconductor by melt-texturing the precursor material under a controlled local partial pressure of a gas that provides a component of the superconducting material, substantially isothermally.

EP 0 517 469 A2

Field of the Invention

This invention concerns a method for producing localised reaction or change of phase at a surface. The principal application for this invention is the fabrication of ceramic superconducting material by a melting or partial melting process. The fabrication method described may be applied to conductors in the form of monoliths that are simply or multiply-connected, or elongated in the form of wires or tapes.

Background of the Invention

An important property of a superconducting material is its ability to carry an electrical current without resistance. This property may, for instance, be exploited in the manufacture of magnetic solenoids and machines, or in monolithic material used for levitation or magnetic screening. If a superconducting circuit is closed on itself, a superconducting current (or supercurrent) may flow without decay; it is then termed a persistent current and the circuit is said to be in persistent mode. When the electric current density through a superconducting material exceeds some limiting value, the current ceases to be a true supercurrent. In this regime, the superconductor shows some electrical resistance to current flow and ceases to be useful for applications. This limiting current density is termed the critical current density and depends strongly on the microstructure of the material, the applied magnetic field and the temperature of the sample. A major objective in the design and optimisation of a superconducting material for application is to maximise the supercurrent it can carry, by maximising its critical current density.

Ceramic superconductors commonly display a low critical current density, particularly in high magnetic fields. This feature is a serious drawback to their widespread application. There are three major factors that can contribute to a low critical current density in these materials.

Firstly, ceramic superconductors are likely to contain narrow planar regions that are non-superconducting. In low magnetic fields, these regions can still pass a small supercurrent called a Josephson supercurrent; however, this current is very strongly degraded by an applied magnetic field. Such regions are termed weak links; in polycrystalline ceramic superconductors, weak links can occur at grain boundaries and at other points in the microstructure. When the material consists of an aggregate of superconducting regions separated by weak links, it is termed a granular superconductor, and the critical current it can carry is said to be determined by the weak link network. In designing and fabricating ceramic superconductors, a major objective is either to eliminate weak links or to cause them to be distributed spatially so as not unduly to interrupt the supercurrent flow.

A second factor that can lead to a low critical current density is the extreme critical current anisotropy often encountered in these materials. In the case of the ceramic YBaCuO, the critical current density in the direction of the crystallographic c-axis is much lower than that in the crystallographic a-b plane. Thus a polycrystalline material with a disordered arrangement of grains is likely to display a reduced critical current density because current is, in certain regions, constrained to pass in the c-axis direction. When there is an applied magnetic field perpendicular to the direction of current flow, the anisotropy is further complicated. If the magnetic field is parallel to the c-axis, the critical current density decreases more rapidly with increasing applied field than for a magnetic field parallel to the a-b plane.

A third factor that also determines the critical current density is the nature of the microstructure and defect structure and the way it interacts with quantised magnetic flux lines, sometimes termed flux vortices. For a material to carry a very high supercurrent in a large magnetic field, it is necessary for the microstructure to contain features that interact strongly with the flux lines, to prevent them moving. Such features are termed pinning centres. For more than two decades it has been a major practical objective to increase the efficiency of pinning centres in technological superconductors by careful control of microstructure. In ceramic superconductors, pinning by point defects is likely to be weak, because the size of the core region of the flux vortex is characteristically small and, at the temperature of operation, the thermal energy tends to activate the flux lines from their pinning centres. Pinning at extended planar features and particularly at interfaces with non-superconducting regions is likely to be more effective because the total pinning energy is larger and pinning is less affected by thermal activation processes.

It is well known that a suitable microstructure may be obtained by directional solidification of the superconducting phase from the melt or partially molten state. This results in the formation of elongated grains with the c-axis perpendicular to the growth direction; the microstructure is then said to be textured and, if suitably doped with inert pinning particles, can carry a high critical current in a direction parallel to the solidification direction. A typical melt-texturing technique consists of heating the material until it is molten or partially molten, and cooling very slowly in a strong temperature gradient. In addition, the sample is sometimes transported through a strong temperature gradient in order to achieve the same effect.

Summary of the Invention

According to the present invention, the melt-texturing process is carried out entirely in an isothermal environment. The sample is neither heated nor cooled during melt-texturing nor is a temperature gradient required as part of the processing. The sample is maintained at a constant temperature below its melting point in a controlled partial pressure of oxygen or another gas.

By means of the present invention, it is possible to fabricate composite ceramic superconductors that exhibit microstructures that are optimised in their crystalline orientation and grain morphology, so that they can carry a high critical current density in large magnetic fields. The novel fabrication method also leads to the incorporation of appropriate non-superconducting flux line pinning centres.

## Description of the Invention

The invention is based on the fact, for oxide superconductors at least, the melting temperature of most ceramic superconductors depends strongly on the partial pressure of oxygen; melting can therefore be achieved without varying the temperature simply by changing the partial pressure of oxygen in the furnace atmosphere. In the case of the superconductor $YBa_2Cu_3O_{7-x}$, for example, the melting point is reduced by about 50°C when the oxygen partial pressure is reduced from 1 atm to 0.1 atm. To achieve directional solidification and melt-texturing, the oxygen partial pressure must be controlled locally within the furnace, to achieve local melting. Directional solidification is achieved by moving or rotating either the sample itself or by moving the pattern of reduced oxygen partial pressure in relation to the sample.

In operation of the invention, local changes in the oxygen partial pressure at the sample surface may be achieved either by supplying the correct mixture of gases to the sample surface through an appropriate arrangement of tubes, ducts and orifices or, alternatively, by electrochemical methods whereby the oxygen activity or partial pressure at the sample surface is altered by titrating oxygen electrochemically through an oxygen fast-ion conductor coating on the surface of the sample.

In either case, the sample may be coated with a layer of silver metal. Silver is oxygen-permeable and the partial pressure of oxygen from the nozzle gas mixture will be conveyed directly through the silver layer to the sample surface where melting will occur if the oxygen partial pressure is appropriately low. Alternatively, a silver layer may be placed between the oxygen fast-ion conductor and the sample surface.

In accordance with a preferred embodiment of the invention, the sample, in the shape of a disc or hollow cylinder, is rotated slowly whilst in close proximity to an array of orifices or nozzles which deliver a gas mixture appropriate to maintain the molten state on the sample surface below each nozzle. As the sample rotates, each nozzle traces out a track over the sample surface and at the same time achieves directional solidification of the material along the path of the track. The nozzles may be circular, oval or slot-like in crosssection. Each nozzle may be in the form of a concentric, peripherally-joined or adjacent pair of orificess, one for the delivery of a flow of the gas mixture and the other for the extraction again of the same gas flow. This arrangement can better localise the gas mixture or partial pressure of oxygen. The second orifice may also be used to introduce a balancing gas mixture to cancel the effect of the first orifice outside its immediate vicinity.

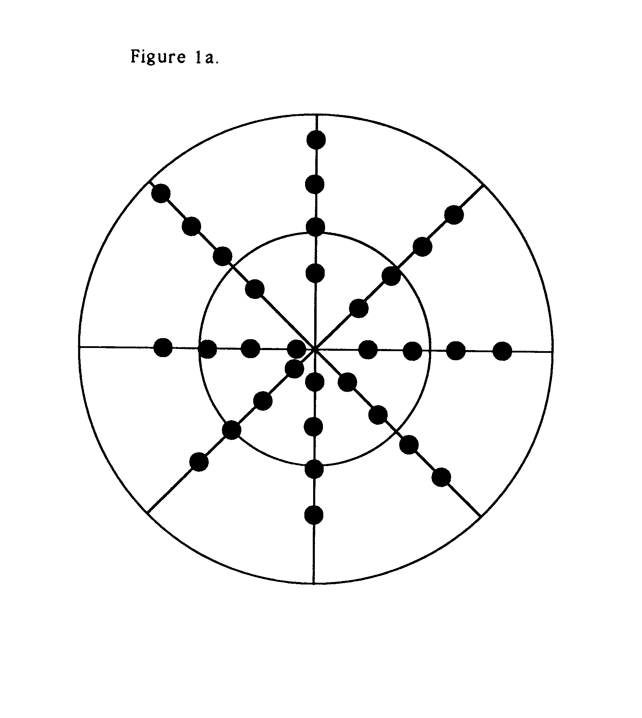

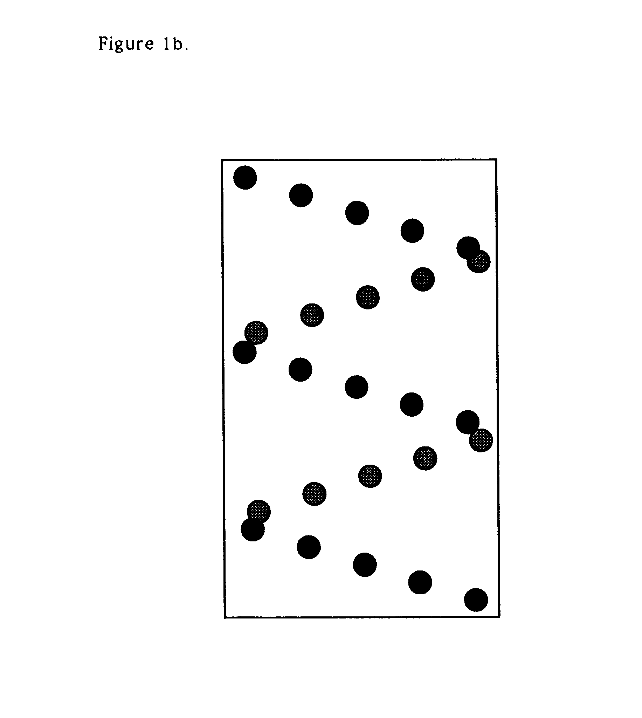

In order to provide a current path for the supercurrent in the sample, the track should preferably be extended in length and provide an opportunity for electrical contacts for supply of current. In one embodiment of the invention, an array of nozzles is arranged so that, after rotation through a fixed angle (for example 45°), each track will impinge on a track already formed by a nozzle displaced only slightly from the track of the first nozzle. If the sequence of nozzles is displaced successively by an appropriate amount in the same direction, then the interconnected arrangement of tracks will form a composite spiral or helical track on the surface of a disc or hollow cylinder. To form the entire composite track will only require a single partial rotation to overlap the successive tracks sufficiently to allow the passage of a high current density from one track segment to the next; in the above example, this might be 60-70°, giving a 15-20° overlap. Arrangements of nozzles respectively appropriate for preparing a spiral or helical composite track are shown in the accompanying Figures 1a (for a spiral track on disk surface) and 1b (for a helical track on the inner or outer surface of a hollow cylinder).

The method described can be used equally well to form directionally-solidified melt-textured tracks with other geometrical layouts over the surface of samples of arbitrary shape. The tracks may penetrate partially through the superconductor precursor material, in which case the melt is retained by surrounding regions of unmelted material. Alternatively, the track may melt the material through its thickness to the substrate below, in which case the substrate is in contact with and retains the liquid. Two tracks on opposing sides of the sample may be arranged so as to penetrate sufficiently deeply to overlap one another. If the nozzles are directly opposed, the molten regions of each track may make contact; alternatively the nozzles may be displaced so that there is no contact of the molten regions.

The width of the tracks may be narrow compared to the sample or may be equal to or exceed the width of the sample. In the latter case, the entire width of the sample is molten to the depth of the track at any time. If, in this case, the depth of the track reaches through the sample thickness, the molten zone will extend across the whole cross-section of the material, separating the directionally-solidified material from material still to be melted. In this case, a suitable substrate for the material has to be provided. Typical geometries for this arrangement are tapes, wires or layers coated onto a supporting wire.

In each case described, the oxygen partial pressure may be alternatively controlled by electrochemical means through a fast-ion conductor by a suitable arrangement of sliding contacts; in a typical arrangement, the sample is coated by plasma-spraying with yttria-stabilised zirconia (YSZ) and a fine pattern of small electrodes is applied which can be contacted sequentially by a sliding contact array. If the applied potential is positive, oxygen will be removed from the sample, the partial pressure or activity will fall, and the sample will melt locally as required. The layer of YSZ may be separated from the sample by a thin layer of silver.

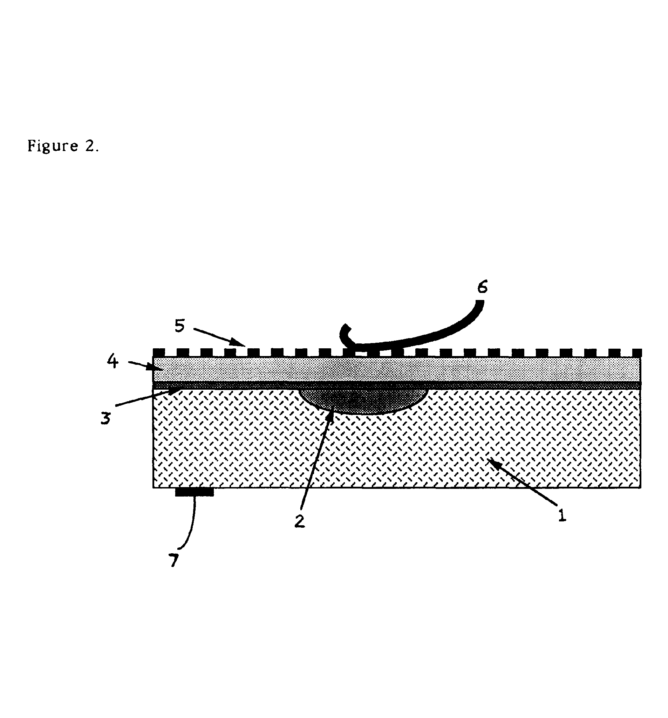

Such an arrangement is illustrated by Figure 2 of the accompanying drawings. More particularly, Fig. 2 shows a superconductor precursor 1 including a melt pool 2, an (optional) silver layer 3 and a YSZ coating 4. An electrical contact array 5 is provided on the coating 4, in contact with a positive sliding contact member 6. A negative contact 7 is applied to the precursor 1. The precursor material may have no superconducting properties. Alternatively, it may be a superconductor, i.e. a material that is superconducting at an appropriate temperature, which is polycrystalline or has other properties that is desired to improve. The novel method thus provides (enhanced) superconducting properties.

Particular features of the present invention are the following:

1. The melt-textured tracks may be singular or consist of two or more parallel tracks.

2. Tracks may preferably be formed in a double pass process with a secondary nozzle following shortly after each primary nozzle.

3. To increase the speed of the directional solidification process, the molten region can be stirred using incident ultrasonic or rf microwave power. Any extra temperature changes induced in this way can be tolerated by adjusting the oxygen partial pressures.

4. The nozzle pressure may be pulsed or varied cyclically to oscillate or stir the melt pool.

5. The oxygen partial pressure may be pulsed or varied cyclically to achieve non-uniform motion, or interruption of the solidification front.

6. The intra and intra-track materials may be similar or disparate in nature.

7. The sample may be mechanically reinforced between the tracks, to place the entire composite under compression, to avoid cracking.

8. The material that is to be melted during directional solidification may consist, prior to melting, of a composite of different layers of material or a mixture of materials. In this way, doping material or seeding material may be introduced to the melt pool.

9. The sample may contain inert high melting point material particles for flux pinning that are incorporated into the track during the melt-texturing process.

10. Inert particles may be supplied to the pool melt carried in the gas stream via the nozzles.

11. The nozzles may move relative to each other and may be made to spin.

12. The directional solidification process may be carried out in an applied magnetic field, to assist directional texturing.

## Claims

1. A method for converting a precursor material to a material having superconducting properties, which comprises melt-texturing the precursor material under a controlled local partial pressure of a gas that provides a component of the superconducting material, substantially isothermally.

2. A method according to claim 1, in which the superconducting material is an oxide superconductor and the gas is oxygen.

3. A method according to claim 1 or claim 2, which comprises relatively moving the material and the locus of the controlled partial pressure, to provide directional solidification.

4. A method according to claim 3, wherein the precursor material comprises, and/or the gas is applied together with, inert particles, to provide flux pinning centres and/or doping or sealing centres.

5. A method according to claim 3 or claim 4, wherein a plurality of controlled local partial pressure is used, to provide a composite helical solidified track.

6. A method according to any preceding claim, in which the precursor material is coated with Ag or another material that is permeable to the component.

7. A method according to any preceding claim, in which the component is titrated electrochemically through an ion-conductor coating.

8. A method according to any of claims 1 to 6, in which the gas is supplied through one of two concentric or adjacent nozzles and, through the other nozzle, either the gas is extracted or a balancing gas is supplied.

Figure 1a.

Figure 1b.

Figure 2.